**Europäisches Patentamt**

**European Patent Office**

**Office européen des brevets**

(19)

(11) Numéro de publication : **0 300 904 B1**

# FASCICULE DE BREVET EUROPEEN

(12)

(45) Date de publication du fascicule du brevet :
**02.01.92 Bulletin 92/01**

(21) Numéro de dépôt : **88401883.9**

(22) Date de dépôt : **20.07.88**

(51) Int. Cl.⁵ : **C30B 25/02,** C30B 23/02, C30B 25/14, C30B 25/10, C30B 29/40, C30B 29/48, H01L 21/205

(54) **Procédé de croissance épitaxiale de couches en matériau III-V ou II-VI par modulation rapide de la température.**

(30) Priorité : **21.07.87 FR 8710290**

(43) Date de publication de la demande :
**25.01.89 Bulletin 89/04**

(45) Mention de la délivrance du brevet :
**02.01.92 Bulletin 92/01**

(84) Etats contractants désignés :
**DE GB**

(56) Documents cités :
**GB-A- 2 162 369**
**GB-A- 2 163 000**
**US-A- 3 721 583**
**US-A- 4 261 771**
**US-A- 4 493 977**
**JOURNAL OF THE ELECTROCHEMICAL SOCIETY, vol. 131, no. 12, décembre 1984, pages 3028-3029, Manchester, New Hampshire, US; S.C. PALMATEER et al.: "Molecular beam epitaxial growth on radiation-heated substrates"**

(56) Documents cités :
**APPLIED PHYSICS LETTERS, vol. 48, no. 26, 30 juin 1986, pages 1787-1789, New York, US; A. DOI et al.: "Growth of GaAs by switched laser metalorganic vapor phase epitaxy"**
**PATENT ABSTRACTS OF JAPAN, vol. 11, no. 246 (C-439)[2693], 11 août 1987; & JP-A-62 52 199 (NEC CORP.) 06-03-1987**
**JOURNAL OF APPLIED PHYSICS, vol. 60, no. 6, 15 septembre 1986, pages 2003-2007, Woodbury, New York, US; A.P. ROTH et al.: "Growth of GaxIn1-xAs by low-pressure metalorganic vapor-phase epitaxy"**

(73) Titulaire : **Nissim, Yves**
**57 Quai de Dion Bouton**
**F-92800 Puteaux (FR)**
Titulaire : **BENSOUSSAN, Marcel**
**881 Cours Aquitaine**
**F-92100 Boulogne (FR)**

(72) Inventeur : **Nissim, Yves**
**57 Quai de Dion Bouton**
**F-92800 Puteaux (FR)**
Inventeur : **BENSOUSSAN, Marcel**
**881 Cours Aquitaine**
**F-92100 Boulogne (FR)**

(74) Mandataire : **Mongrédien, André et al**
**c/o BREVATOME 25, rue de Ponthieu**
**F-75008 Paris (FR)**

EP 0 300 904 B1

Jouve, 18, rue Saint-Denis, 75001 PARIS

## Description

L'invention a pour objet un procédé de croissance épitaxiale de couches semi-conductrices en matériau III-V ou II-VI éventuellement dopé, permettant la réalisation de structures semi-conductrices multicouches utilisables notamment en micro-électronique pour la réalisation des circuits intégrés et en opto-électronique pour la réalisation de sources laser, ces dernières pouvant éventuellement être intégrées sur le même substrat que leur(s) transistor(s) de commande.

On rappelle qu'un matériau III-V est un matériau contenant au moins un élément de la colonne III et au moins un élément de la colonne V de la classification périodique des éléments. De même, un matériau II-VI est un matériau comptant au moins un élément de la colonne II et au moins un élément de la colonne VI.

La réalisation de structures semi-conductrices multicouches avec des transitions abruptes aux interfaces, tant en modulation de la composition de ces couches qu'en modulation de leur dopage, nécessite une bonne maîtrise des techniques de dépôt des matériaux semi-conducteurs et en particulier des techniques de croissance épitaxiale.

Le nombre de couches nécessaires à la réalisation de dispositifs semi-conducteurs peut aller de quelques couches à une centaine de couches suivant la complexité de la fonction recherchée. Les épaisseurs de ces couches doivent souvent être très faibles (< 10 nm) notamment pour les dispositifs semi-conducteurs comportant des puits quantiques tels que des lasers à puits quantiques, des dispositifs à super-réseaux, des structures GRINSCH (hétérostructure de confinement à gradient d'indice) ou des SEED (bistables optiques), d'où la nécessité impérieuse de bien maîtriser les raideurs d'interface, à la monocouche près.

On rappelle qu'une monocouche pour un matériau binaire AB correspond à une rangée d'atomes A plus une rangée d'atomes B et que l'épaisseur de cette monocouche est égale à a/2, a étant l'un des paramètres cristallographiques du réseau cristallin de AB.

Actuellement, trois techniques de croissance épitaxiale s'imposent pour la réalisation de structures multicouches : la croissance par jet moléculaire, notée MBE en abrégé, opérant dans des conditions d'ultra-vide ; la croissance en phase vapeur utilisant des composés organo-métalliques et opérant sous pression atmosphérique ou basse pression, notée en abrégé MOCVD, et la combinaison des deux techniques notées MOMBE ou MBE chimique ou MBE gaz.

On rappelle qu'en MBE le processus de croissance est essentiellement lié aux phénomènes d'adsorption et de désorption des espèces chimiques, nécessaires à la croissance, qui arrivent sur le substrat sous forme élémentaire ; alors qu'en MOCVD ou en MOMBE le phénomène d'adsorption s'accompagne d'un phénomène de décomposition thermique ou pyrolyse d la surface du substrat des molécules contenant l'élément à déposer.

On rappelle en outre que la croissance épitaxiale est un dépôt reproduisant le motif et la symétrie cristallins du substrat sur lequel s'effectue la croissance (conservation des paramètres cristallins du substrat).

L'optimisation des conditions de croissance procède en général d'une démarche empirique car les mécanismes fondamentaux, notamment en MOCVD et en MOMBE, à la base de la croissance épitaxiale sont très mal connus. En particulier, le rôle de la température de croissance est diversement apprécié dans les réactions chimiques qui ont lieu à la surface du substrat pendant la croissance.

Pourtant, la température est l'un des paramètres de croissance les plus délicats à optimiser car les conditions opératoires de dépôt sont modifiées à chaque fois que l'on modifie la température. En effet, la température de croissance influe sur la vitesse de croissance, sur la morphologie de la surface de la couche déposée, sur l'incorporation ou non d'impuretés non intentionnelles, sur l'incorporation intentionnelle de dopants, sur la diffusion de défauts, sur l'exodiffusion des impuretés introduites volontairement dans le substrat, etc.

Compte tenu du rôle complexe joué par la température de croissance, cette dernière est généralement choisie afin d'arriver à un compromis entre la vitesse de croissance, la morphologie de la couche déposée et la nature du dopage recherché pour cette couche.

Dans les trois techniques de croissance MOCVD ou MBE ou MOMBE, en général on fixe une fois pour toutes la température de chauffage du substrat sur lequel doit être déposée la ou les couches semi-conductrices, cette température est comprise entre 400 et 800°C pour les matériaux III-V et entre 200 et 700°C pour les matériaux II-VI.

En croissance MBE, compte tenu de la transposabilité des conditions expérimentales d'un bâti de dépôt à un autre, le choix de la température de croissance est assez normalisé. En revanche, ceci l'est beaucoup moins en croissance MOCVD, les températures optimales de croissance dépendant fortement de la configuration des réacteurs de dépôt, configuration qui est loin d'être normalisée. Aussi, chaque laboratoire détermine sa température de croissance selon le bâti, l'endroit et la nature de la couche à déposer. En croissance MOMBE, technologie beaucoup plus récente, les conditions de croissance sont encore bien loin d'être normalisées.

Le fait d'avoir à modifier très peu la température de croissance a entraîné la réalisation de dispositifs de chauffage du substrat, présentant des inerties thermiques importantes (quelques dizaines de minutes) interdisant pratiquement tout pilotage rapide de la température en cours de croissance. Ce pilotage s'impose de plus en plus si l'on veut réduire les temps de croissance et les phénomènes d'incorporation ou de migration de défauts ainsi que l'extension des interfaces dans des structures multicouches.

Par ailleurs, comme phénomènes parasites dépendant de la température de croissance (que l'on peut contourner en influant sur la cinétique de croissance), on peut citer l'incorporation non intentionnelle d'oxygène dans les composés à base d'aluminium, compte tenu de la réactivité de ce dernier, l'incorporation d'impuretés résiduelles du bâti de dépôt notamment pour la croissance de GaAs intrinsèque ou dopé, la création de défauts de stoechiométrie nécessitant soit des dopages de compensation, soit un contrôle précis de la composition de la couche déposée.

Ce contrôle de composition est particulièrement délicat quand on travaille à température fixe pour des composés ternaires et quaternaires à base de phosphore et d'arsenic réalisés à partir de la décomposition thermique de la phosphine ($PH_3$) et de l'arsine ($AsH_3$) compte tenu de la grande différence de rendement de la décomposition de ces matériaux en fonction de la température de ces deux gaz.

L'influence de la température sur la création de défauts de stoechiométrie dans la croissance de GaAs a notamment été décrite dans l'article "Deposition of GaAs epitaxial Layers by Organometallic CVD. Temperature and Orientation Dependence" de D.H. Reep et al, Journal Electronichemical Society, vol. 130, n°3, pp. 675-680 de mars 1983.

L'influence de la température de croissance sur la composition des composés à base de P et d'As a notamment fait l'objet d'une publication de C.R. LEXIS et al. "The compositional grading of MOCVD-grown GaAs$_{1-x}$ P$_x$ via substrate temperature changes" paru dans Journal of Electronic Materials, vol. 13, n°5, 1984, pp. 749-761.

L'influence de la température sur l'incorporation d'oxygène dans les composés à base d'Al a notamment été décrite dans l'article "The effects of the growth temperature on Al$_x$ Ga$_{1-x}$ As ($0 \leq x \leq 0,37$) led materials grown by OM-VPE" de M.J. Tsai, Journal of Electronic Materials, vol. 13, n°2, 1984, pp. 437-446.

L'influence de la température est plus diversement appréciée pour la croissance des II-VI comme cela apparaît dans les articles "Organometallic Growth of II-VI compounds" de J.M. Mullin et al., J. Crystal Growth, vol 55, 1981, pp. 92-106, et "An investigation of dimethylcadmium and diethyltelluride by in situ sampling and analysis" de M.R. Czeinick et al., J. Crystal Growth, vol. 68, 1984, pp. 128-135.

Il ressort clairement de ce qui précède que la température de croissance joue un rôle important sur la qualité des couches épitaxiées.

Par ailleurs, pour avoir un contrôle précis de la croissance de couches semi-conductrices, à la monocouche près, il est possible avec les équipements actuels de moduler l'apport en espèces chimiques des éléments III ou II et V ou VI sur le substrat en vue de former des couches monocristallines en matériau III-V ou II-VI, l'apport en éléments III ou II et en éléments V ou VI étant alterné. Cette modulation de l'apport en espèces chimiques a été effectuée jusqu'à présent à température de croissance constante.

Une telle modulation de l'apport en espèces chimiques a fait l'objet de la publication Japanese Journal of Applied Physics, vol. 24, n°12, décembre 1985, pp. L962-L964 de N. Kaboyashi et al., intitulée "Flow-rate modulation epitaxy of GaAs".

Plus récemment, une modulation en température du substrat a été introduite lors de la croissance épitaxiale de couches en matériau III-V, en remplacement de la modulation de l'apport en espèces chimiques des éléments III et V. Cette modulation est décrite dans le document Appl. Phys. Lett. 49 (25), du 22 décembre 1986 de S. Reynolds et al., "Limited reaction processing : growth of III-V epitaxial layers by rapid thermal metalorganic chemical vapor deposition", pp. 1720-1722.

Cette modulation de la température n'est utilisée que pour optimiser la température de croissance de structures multicouches après avoir stabilisé les flux gazeux, ce pour des couches épaisses (> à 10 nm).

L'invention a justement pour objet un procédé de croissance par épitaxie de couches en matériau III-V ou II-VI par modulation rapide de la température permettant en synchronisation avec des changements de gaz, une meilleure optimisation des conditions de croissance et donc notamment un contrôle précis de la croissance des couches semi-conductrices déposées, à la monocouche près, une réduction des temps de croissance, une réduction des phénomènes parasites d'incorporation ou de migration des défauts ainsi que l'obtention d'interfaces abruptes.

De façon plus précise, l'invention a pour objet un procédé de croissance par épitaxie sur un substrat d'une couche semi-conductrice monocristalline formée a) d'au moins un élément III et d'au moins un élément V ou b) d'au moins un élément II et d'au moins un élément VI, consistant à soumettre le substrat, simultanément à l'apport en espèces chimiques donnant les éléments entrant dans la composition de ladite couche, à une série d'impulsions thermiques en forme de créneaux comportant alternativement des paliers de température T1 et des paliers de température T2 supérieurs à la température ambiante, avec T1 < T2, l'apport en espèces chimiques donnant l'élément III ou II de la couche étant effectué pendant que le substrat est à la température T1 et l'apport en espèces chimiques donnant l'élément V ou VI de la couche étant effectué pendant que le substrat est à la température T2 ; T1 et T2 correspondent respectivement aux températures d'adsorption optimales de l'élément III ou II et de l'élément II ou VI sur le substrat.

Le procédé selon l'invention permet le dépôt de couches semi-conductrices, à la monocouche près, et donc la réalisation de structures semi-conductrices multicouches ayant des interfaces abruptes.

Bien qu'une modulation en température soit prévue dans l'article de S. Reynolds ci-dessus, cette modulation est prévue en alternative de la modulation de l'apport en espèces chimiques sur le substrat, ce qui est incompatible avec une modulation rapide des gaz en vue d'obtenir des couches monocristallines, à la monocouche près. Ceci est d'autant plus vrai que cette modulation en température n'est utilisée que pour optimiser la température de croissance de structures multicouches après avoir stabilisé le flux gazeux, ce pour des couches épaisses (> 10 nm).

Le substrat peut être en matériau III-V. II-VI ou IV suivant la nature de la couche à déposer ou en tout autre matériau.

En particulier, dans les cas les plus simples, la croissance épitaxiale selon l'invention se fait sur un substrat AB d'orientation [100], ce qui correspond à des plans cristallins ne comportant au'un seul type d'atomes A ou B (A représentant le ou les éléments III ou II et B le ou les éléments V ou VI par exemple).

De façon avantageuse, la durée de l'apport en espèces chimiques est égale à la durée du palier de température correspondante.

Le procédé selon l'invention peut être utilisé tant en croissance MBE qu'en croissance MOCVD au au'en croissance MOMBE, mais il trouve ses pleines justification et application en croissance MOCVD et MOMBE qui sont des procédés de croissance fondés sur un phénomène de pyrolyse (décomposition thermique + réaction chimique) à la surface du substrat. En particulier, sa mise en oeuvre en MOCYD est beaucoup plus facile. Ceci est notamment lié au fait que les pressions de gaz utilisées sont plus élevées et donc que la durée des dépôts est plus courte : les pressions en MOCVD varient de $10^2$ à $10^6$ Pa.

En outre, il s'agit de bénéficier des derniers progrès réalisés sur les fours à recuit rapide par lampes flash à halogène présentant un grand nombre d'avantages.

En effet, les fours à lampes à halogène présentent un temps de montée en température extrêmement rapide, voisin de 3 ms/°C, une parfaite stabilité sur le palier de température choisie (+ 1%), grâce à une contre-réaction analysant directement la température induite sur l'échantillon par thermocouple ou pyromètre optique, un temps de descente en température extrêmement rapide, voisin de 7 à 10 ms/°C, ce temps étant largement suffisant pour arrêter une croissance instantanément à l'échelle de la monocouche, un chauffage uniforme à plus ou moins 3%.

Dans un four à lampes à halogène, l'homogénéité en température est assurée par la forme des lampes et le montage de l'échantillon à traiter, ce dernier étant sans contact thermique avec son support (échantillon flottant) assurant ainsi une faible inertie thermique.

En croissance MOCVD, il existe deux régimes de croissance :
— un régime haute température ou la croissance est régie par diffusion des espèces au travers de la couche stagnante au-dessus du substrat et où la vitesse de croissance est peu sensible à la température du substrat, et
— un régime basse température où la croissance est régie par la cinétique de surface et où la vitesse de croissance croît linéairement en fonction de la température.

Le procédé selon l'invention est applicable aux deux régimes de croissance mais conduit à des effets plus spectaculaires dans le cas d'un régime à basse température.

Conformément à l'invention, la modulation de la température de croissance et celle des flux gazeux nécessaires à l'apport en espèces chimiques sur le substrat permet de minimiser les taux de réaction homogène en phase gazeuse, phénomène qui est toujours nuisible à la qualité de la croissance.

En croissance MOCVD et MOMBE, les températures T1 et T2 correspondent aux températures de décomposition thermique optimale des espèces chimiques à la surface du substrat donnant respectivement l'élément III ou II et l'élément V ou VI de la couche monocristalline. La modulation en température du substrat, conformément à l'invention, permet d'utiliser la température optimale pour le craquage ou décomposition thermique de chaque gaz à la surface du substrat, limitant ainsi les phénomènes parasites cités précédemment.

En croissance MBE les températures T1 et T2 sont les températures qui assurent le meilleur compromis entre adsorption et désorption des éléments III ou II et V ou VI à la surface du substrat.

Le procédé selon l'invention s'applique à tout matériau III-V binaire, ternaire ou quaternaire. En particulier, l'élément III est choisi parmi le gallium, l'indium, l'aluminium et leurs mélanges, et l'élément V est choisi parmi le phosphore, l'arsenic, l'antimoine et leurs mélanges.

De même, l'invention s'applique à tout matériau II-VI binaire, ternaire ou quaternaire. Toutefois, l'élément

Il est de préférence choisi parmi le zinc, le cadmium, le mercure et leurs mélanges et l'élément VI parmi le soufre, le sélénium, le tellure et leurs mélanges.

La croissance de couches en matériau III-V en MOCVD et en MOMBE se fait soit par décomposition thermique de polyalkyle de l'élément III et de polyalkyle de l'élément V, soit par décomposition thermique de polyalkyle de l'élément III et de composé hydrogéné de l'élément V. De même, la croissance de matériau II-VI en MOCVD et en MOMBE se fait soit par décomposition thermique de polyalkyle de l'élément II et de polyalkyle de l'élément VI, soit par décomposition thermique de polyalkyle de l'élément II et de composé hydrogéné de l'élément VI. Le mercure peut également être utilisé directement sous forme de vapeurs.

Les radicaux alkyle utilisés sont des radicaux comportant de 1 à 3 atomes de carbone.

En particulier, le dépôt de couches semi-conductrices contenant du gallium, de l'indium ou de l'aluminium se fait respectivement par décomposition de triméthylgallium (TMGa). de triéthylgallium (TEGa) ou de chlorure de diéthylgallium (DEGaCl) ; de triéthylindium (TEIn) ou de triméthylindium (TMIn) et de triméthylaluminium (TMAl).

Le dépôt de couches semi-conductrices contenant du phosphore, de l'arsenic ou de l'antimoine se fait par décomposition respectivement de phosphine ($PH_3$) ou de triméthylphosphine (TMP), triéthylphosphine (TEP); d'arsine ($AsH_3$) ou de triméthylarsine (TMAs) ; d'hydrure d'antimoine ($SbH_3$) ou de triméthylantimoine (TMSb).

Le dépôt de couches contenant du zinc, du cadmium ou du mercure se fait par décomposition respectivement de diéthylzinc (DEZn) ou de diméthylzinc (DMZn), de diméthylcadmium (DMCd) ou de diéthylcadmium (DECd) et de mercure. Pour le dépôt de couches contenant du soufre, du sélénium ou du tellure, on utilise respectivement des vapeurs d'hydrogène sulfuré ($H_2S$), d'hydrogène sélénié ($H_2Se$), de triméthyltellure (DMTe) ou de diéthyltellure (DETe).

Les produits pour la croissance sont généralement véhiculés jusqu'au substrat par un gaz porteur ($H_2$, $N_2$ ou He). Le gaz habituellement utilisé est l'hydrogène. Les pressions partielles des produits qui interviennent dans la croissance comme les polyalkyles ou les hydrures sont à calculer en fonction de la vitesse de croissance recherchée qui est également fonction des débits de gaz et des températures utilisés. Pour des vitesses de croissance de l'ordre du µm/h, les pressions partielles des gaz préconisés ici sont dans la gamme des $10^2$ Pa pour des débits de quelques litres/min.

Les caractéristiques de ces gaz ainsi que les réactions de décompositions chimiques mises en jeu lors du dépôt des couches en matériau III-V ou II-VI sont notamment données dans Ann. Rev. Mater. Sci.. 1982, 12 : 243-269 de P. Daniel Dapkus, "Metalorganic Chemical Vapor Deposition".

Le procédé selon l'invention s'applique aussi bien à la croissance épitaxiale d'une ou plusieurs couches semi-conductrices dopées qu'à la croissance de couches non dopées.

Dans le cas de couches semi-conductrices III-V dopées n, l'apport en espèces chimiques donnant le dopant n est généralement effectué pendant que le substrat est à la température T1.

Pour la croissance d'une couche semi-conductrice III-V dopée p, l'apport en espèces chimiques donnant le dopant p est généralement effectué pendant que le substrat est à la température T2.

Pour la croissance d'une couche semi-conductrice II-VI dopée on peut opérer de la même manière que pour la couche III-V ou faire l'inverse en ce qui concerne les cycles d'introduction des dopants suivant la nature du composé utilisé pour le dopage de la couche. Ce point sera précisé plus loin dans les exemples.

Conformément à l'invention, pour la croissance d'une couche semi-conductrice en MOCVD ou en MOMBE, comportant deux éléments de la même colonne du tableau périodique des éléments pour lesquels les températures de décomposition des espèces chimiques donnant ces deux éléments différents sont voisines. L'apport en espèces chimiques de ces deux éléments sur le substrat est réalisé simultanément.

En revanche pour la croissance d'une couche semiconductrice en MOCVD ou en MOMBE comportant deux éléments de la même colonne du tableau périodique des éléments pour lesquels les températures de décomposition des espèces chimiques donnant ces deux éléments sont différentes, les apports en espèces chimiques respectivement de ces deux éléments sur le substrat sont réalisés successivement ; les impulsions du traitement thermique du substrat présentent alors des paliers de température supplémentaires T3 avec T1 < T3 < T2 pendant lesquels on effectue l'apport de l'espèce chimique ayant la température de décomposition la plus basse.

Ceci est en particulier le cas pour des matériaux III-V ternaires ou quaternaires comportant à la fois de l'arsenic et du phosphore. C'est également le cas pour les matériaux II-VI ternaires ou quaternaires comportant à la fois du soufre ou du sélénium et du tellure.

Cette remarque s'applique également pour l'incorporation de dopants.

D'autres caractéristiques et avantages de l'invention ressortiront mieux de la description qui va suivre, donnée à titre illustratif et non limitatif, en référence aux figures annexées, dans lesquelles :

— les figures 1 à 6 sont des diagrammes donnant au cours du temps (t) le cycle de température (T) et d'introduction des gaz (F) dans l'enceinte de dépôt pour la croissance monocristalline de couches semi-conductrices en matériau III-V ou II-VI : les figures 1 à 5 se rapportent respectivement à la croissance de GaAs, InP, GaInAs, GaAs/AlAs, GaAsP, la figure 6 à la croissance de couches binaires II-VI, et
— la figure 7 représente schématiquement un dispositif permettant la mise en oeuvre du procédé selon l'invention.

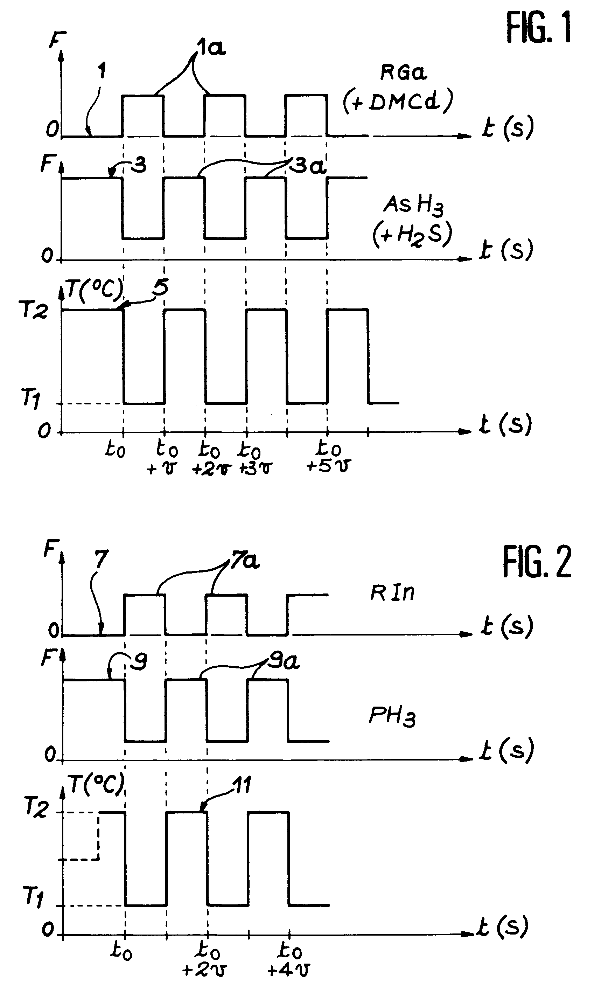

La figure 1 est relative à la croissance d'une couche de GaAs, dopé ou non, par décomposition chimique en phase vapeur de TMGa ou de TEGa, noté RGa, avec de l'arsine $AsH_3$. Les courbes 1 et 3 se rapportent respectivement à l'apport en gallium et à l'apport en arsenic sur un substrat monocristallin en GaAs par exemple d'orientation cristalline [100].

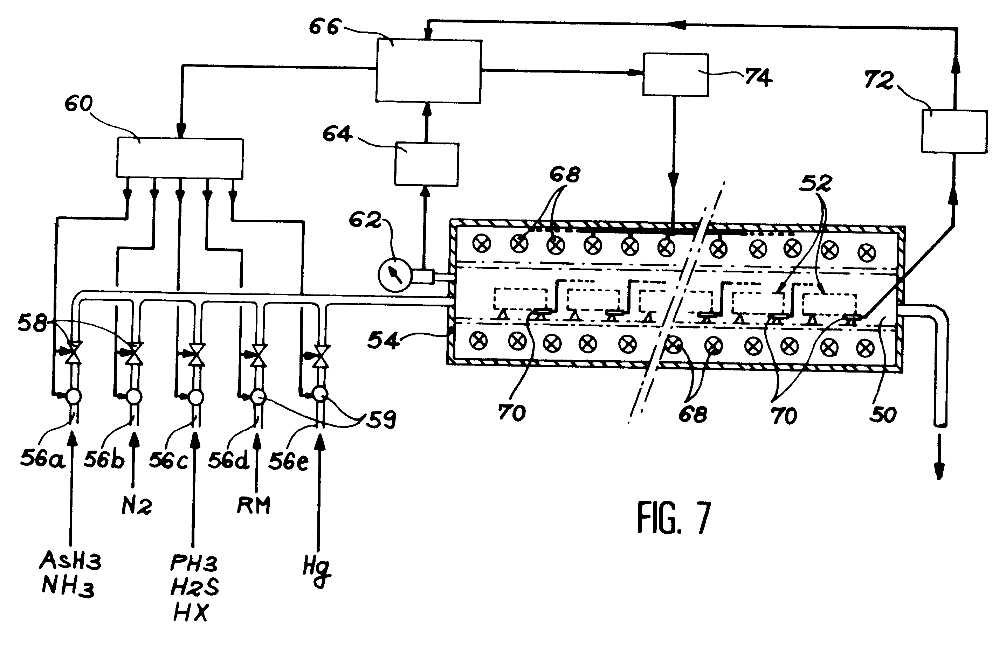

Ces courbes se présentent sous la forme d'une série d'impulsions périodiques en forme de créneaux, les paliers 1a correspondant à l'alimentation en RGa de l'enceinte de dépôt (figure 7) et les paliers 3a correspondant à l'alimentation en arsine de l'enceinte de dépôt, sont alternés.

Simultanément à cette modulation des gaz de dépôt, on effectue une modulation en température du substrat sur lequel doit être déposée la couche de GaAs. La courbe 5, correspondant à cette modulation en température, se présente aussi sous la forme d'impulsions thermiques périodiques en forme de créneaux comportant alternativement des paliers de température T1 et des paliers de température T2, avec T2 > T1.

Comme le montre la figure 1, le substrat est porté à la température T1 lorsque l'on introduit dans l'enceinte de dépôt l'alkylgallium et le substrat est porté à la température T2 lorsque l'on introduit dans l'enceinte de dépôt l'arsine. Les alimentations en gaz et la modulation en température sont parfaitement synchronisées.

Les températures T1 et T2 sont proches, voire identiques, aux températures de décomposition respectivement de RGa et de $AsH_3$ à la surface du substrat.

En régime d diffusion, c'est-à-dire de hautes températures, la température T1 est égale à 500 ± 20°C et la température T2 est égale à 700 ± 20°C. Pour un régime de cinétique de surface, c'est-à-dire de basses températures, la température T1 est égale à 300 ± 20°C et la température T2 à 500 ± 20°C. Le temps de présence de l'alkylgallium (RGa) et celui de l'arsine dans l'enceinte de dépôt sont identiques.

De même, la durée du palier T1 est identique à la durée du Palier T2 ; la demi-période v des impulsions de la courbe 5 est égale à 1 seconde, ce qui est le temps nécessaire pour déposer une monocouche de GaAs non dopé, soit une épaisseur de ordre de 0,3 nm de GaAs, avec une pression de gaz de $10^3$ Pa.

La durée totale de l'apport en gaz (paliers 1a et 3a) nécessaire au dépôt et donc celle du traitement thermique (paliers T1 et T2), sont directement proportionnelles à l'épaisseur de la couche de GaAs que l'on désire obtenir. Typiquement, en régime hautes températures, le dépôt d'une couche de GaAs de 30 nm nécessite un temps total de 10 s, ce qui est relativement court.

Le dépôt d'une couche en matériau III-V est généralement précédé d'une étape de préparation de la surface du substrat sur lequel s'effectue le dépôt. Cette préparation consiste en un apport en élément V à la surface du substrat en vue de compenser les lacunes de cet élément à la surface dudit substrat.

C'est pour cette raison que le premier gaz introduit dans l'enceinte de dépôt est celui de l'élément V et que l'on porte le substrat à la température T2. La durée de l'apport en élément V à la surface du substrat n'est pas critique, il suffit qu'elle soit supérieure à 1 s, temps nécessaire à saturer la surface en élément V. La croissance épitaxiale proprement dite de la couche monocristalline en matériau III-V ne débute qu'au temps to.

Pour obtenir une couche de GaAs dopé p, l'introduction et la suppression du dopant dans l'enceinte de dépôt, qui est en général un élément de la colonne II du tableau périodique des éléments, s'effectuent le plus souvent simultanément et de façon synchronisée avec l'alimentation respectivement la suppression de l'alkylgallium, comme indiqué sur la figure 1. Ceci tient au fait que les principaux dopants p utilisés sont obtenus par décomposition d'organo-métalliques et que leur température de décomposition est proche de celle de l'organo-métallique de l'élément III et que les éléments accepteurs sont substitutionnels sur les sites du sous-réseau III.

Comme dopant p on peut par exemple citer le cadmium obtenu par décomposition de DMCd.

Pour obtenir une couche de GaAs dopé n, ce qui correspond généralement à l'incorporation des éléments de la colonne VI du tableau périodique des éléments en site substitutionnel sur le sous-réseau V, l'introduction et la suppression du gaz dopant dans l'enceinte de dépôt se font en général simultanément et de façon synchronisée avec celles de l'arsine, comme indiqué sur la figure 1. Ceci tient, là encore, au fait que les dopants généralement utilisés (S) sont obtenus par décomposition de composés hydrogénés ($H_2S$) et que leur température de décomposition est proche de celle de l'arsine.

Il est bien entendu possible de déposer une couche de GaAs en utilisant du triméthyle d'arsenic à la place de l'arsine, le cycle thermique et d'alimentation en gaz étant identiques à ceux de l'arsine.

Lorsque l'on désire réaliser un empilement de couches de même composition AB mais dopées différemment, il est possible de moduler la température du substrat ainsi que l'alimentation en dopant de façon synchronisée. Ceci est notamment le cas pour la réalisation de couches alternées de p-GaAs et de GaAs non dopé intentionnellement. Cette modulation de la température en fonction du dopage est en particulier possible lorsque le dopant p utilisé est du zinc, celui-ci nécessitant des basses températures tout en restant dans le régime de diffusion. Une température de l'ordre de 600°C est parfaitement bien adaptée. Des températures de croissance supérieures à 600°C entraînent une exodiffusion du zinc dans les couches sous-jacentes non dopées. Le zinc est introduit dans l'enceinte de dépôt sous forme de DMZn ou DEZn simultanément avec le DMGa, uniquement pendant le temps nécessaire à l'obtention d'une couche dopée.

En alternance à cette structure, on peut former une couche de n-GaAs de la façon décrite précédemment. On obtient ainsi une structure (nipi). Les cycles de température et d'apport de gaz sont une alternance des cycles ci-dessus décrits pour former des couches p-GaAs/ GaAs/n-GaAs successivement.

Les courbes de la figure 2 sont relatives au dépôt d'une couche de InP, non intentionnellement dopé, par décomposition thermique à la surface du substrat de triméthylindium ou de triéthylindium (noté RIn) et de phosphine. La courbe 7 correspond au cycle d'introduction et d'arrêt de l'alkylindium et la courbe 9 au cycle d'introduction et d'arrêt de la phosphine.

Comme pour la figure 1, ces courbes 7 et 9 présentent la forme de créneaux périodiques. l'apport en indium sur un substrat en InP d'orientation [100] correspondant au palier 7a de la courbe 7 et l'apport en phosphore correspondant au palier 9a de la courbe 9 sont alternés.

Simultanément à cet apport en gaz, on trouve une modulation de la température du substrat sur lequel s'effectue le dépôt de la couche d'InP. Ce traitement thermique se présente encore sous la forme d'une série d'impulsions thermiques périodiques en forme de créneaux comportant alternativement des paliers à la température T1 et des paliers 4 la température T2 avec T1 < T2, le substrat étant porté à la température T1 pendant l'apport en alkylindium et à la température T2 pendant l'apport en phosphine.

Les apports en espèces chimiques et la modulation en température sont parfaitement synchronisés, comme précédemment. La durée des impulsions thermiques v, égale à celle des apports en indium et en phosphore, est comprise entre 1 et 10 s afin d'obtenir une monocouche d'InP de 0,3 nm d'épaisseur avec une pression gazeuse de $10^3$ Pa.

En régime hautes températures, T1 est égal à $400 \pm 20°C$ et T2 à $800 \pm 20°C$, ce qui correspond aux températures de décomposition respectivement de TMIn et PH$_3$ à la surface du substrat.

Il est aussi possible de déposer une couche d'InP dopé n ou p en utilisant respectivement de l'H$_2$S et du DMCd. L'H$_2$S est introduit en même temps que la phosphine et le MCd en même temps que l'alkylindium.

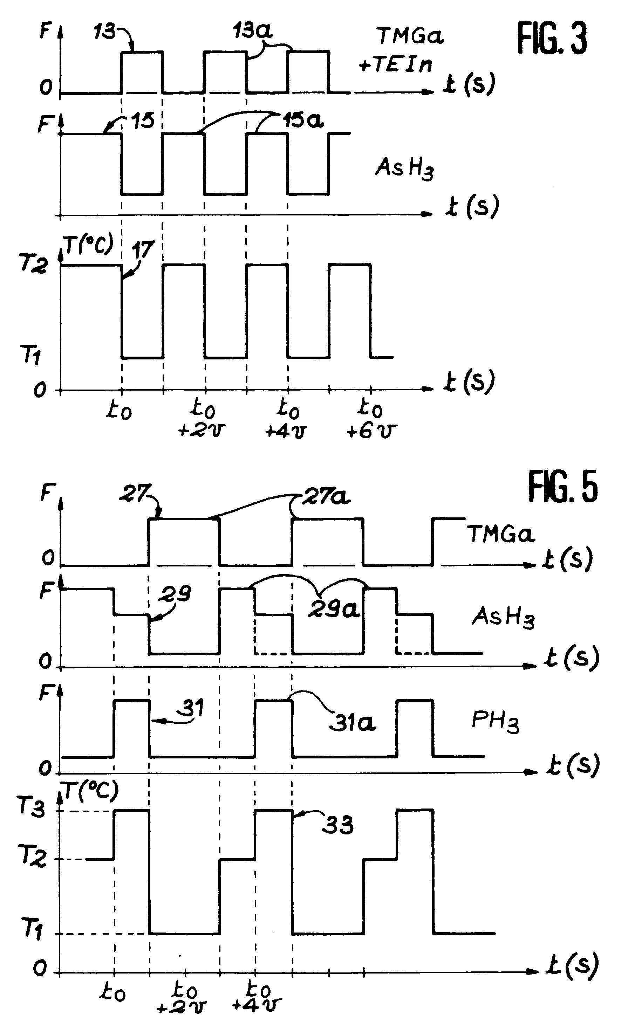

La figure 3 correspond à la croissance d'une couche ternaire du type Ga$_x$ In$_{1-x}$As obtenue par décomposition thermique de triméthylgallium, de triméthylindium et d'arsine à la surface du substrat. Le cycle de croissance de ces composés est identique à celui du GaAs illustré sur la figure 1 avec comme exception l'apport en triéthylindium sur un substrat en InAs ou GaAs d'orientation [100], en même temps que l'apport en triméthylgallium.

Aussi, la courbe 13 correspond aux cycles simultanés du triméthylgallium et du triméthylindium, la courbe 15 au cycle de l'arsine et la courbe 17 donne la modulation en température correspondante.

Comme précédemment, le substrat III-V est porté à la température T1 < T2 pendant l'apport en gallium et en indium, représenté par le palier 13a de la courbe 13, et successivement à la température T2, pendant l'apport en arsine, correspondant au palier 15a de la courbe 15. La durée des impulsions thermiques et de l'apport en gaz de dépôt v varie de 1 à 10 s afin d'obtenir une monocouche de Ga$_x$ In$_{1-x}$ As de 0,3 nm d'épaisseur.

La valeur de l'indice x est fixé par les pressions partielles de TMGa et de TEIn régnant dans l'enceinte de dépôt.

Le dopage n ou p de ces matériaux ternaires est réalisé, comme décrit en référence à la figure 1, l'apport en dopant n étant effectué simultanément à celui d'ASH$_3$ et l'apport en dopant p étant effectué simultanément à ceux de TMGa et TEIn.

De la même façon, il est possible de déposer des couches de Ga$_x$In$_{1-x}$P, avec 0 < x < 1, dopé ou non, par décomposition thermique de trimétylgallium, de trimétylindium et de phosphine. La modulation des flux gazeux et celle de la température de chauffage du substrat sont identiques à celles représentées sur la figure 3, si ce n'est que l'on remplace l'apport en arsine par l'apport en phosphine.

La phosphine pouvant se décomposer partiellement entre 700 et 800°C, il est possible de choisir la composition en phosphore des composés du type GaInP en fonction de la température de chauffage du substrat, température correspondant au palier T2 du traitement thermique impulsionnel.

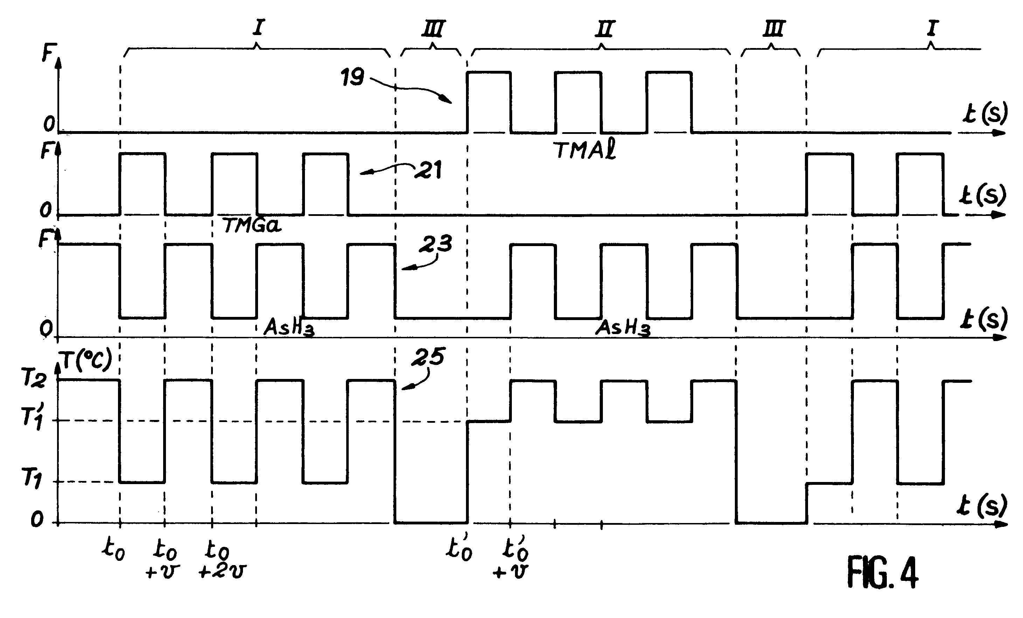

Les courbes représentées sur la figure 4 correspondent à la croissance épitaxiale d'un pseudo-alliage ou de couches alternées de GaAs/AlAs à partir de la décomposition thermique de TMGa, TMAl et d'arsine. Les courbes 19, 21 et 23 correspondent respectivement à l'apport en TMAl, TMGa et arsine sur un substrat en GaAs ou AlAs d'orientation [100].

La courbe 25 représente la modulation en température associée à cette modulation en gaz de croissance. Les parties I de la figure 4 correspondent au dépôt de GaAs et les parties II correspondent au dépôt d'AlAs.

Le dépôt de GaAs se fait comme décrit en référence à la figure 1, les apports en TMGa et en arsine sur le substrat étant alternés, l'apport en arsine se faisant à la température T2 et l'apport en TMGa à la température T1 avec T2 > T1 voisins respectivement de 500 et 700 ± 20°C en régime de diffusion.

De même, les apports en TMAl et en arsine sont alternés. La température du substrat est maintenue à la température T2 de décomposition de l'arsine à la surface du substrat pendant l'apport en arsine et le substrat est maintenu à la température T'1, voisine de la température de décomposition de TMAl à la surface du substrat pendant l'apport en TMAl.

Le TMAl nécessitant des températures de décomposition thermique aussi élevées que celles de l'arsine, et ceci pour éviter l'incorporation d'oxygène dans la couche semi-conductrice, il est possible de choisir T'1 identique à T2 et voisin de 700°C en régime de diffusion.

Le cycle de dépôt de GaAs puis celui de AlAs sont répétés autant de fois que nécessaire suivant l'épaisseur de la couche de pseudo-alliage que l'on désire obtenir. Le rapport des durées des parties I et II fixe la composition moyenne du pseudo-alliage.

Après chaque dépôt de GaAs et d'AlAs, la température du substrat est ramenée à la température ambiante. Le changement de gaz pour permettre le dépôt de AlAs respectivement de GaAs est effectué pendant la période III de refroidissement du substrat, dont la durée est d'environ 15 s.

Le dopage n ou p de ce pseudo-alliage est en particulier réalisé dans les mêmes conditions que celles décrites en référence à la figure 1.

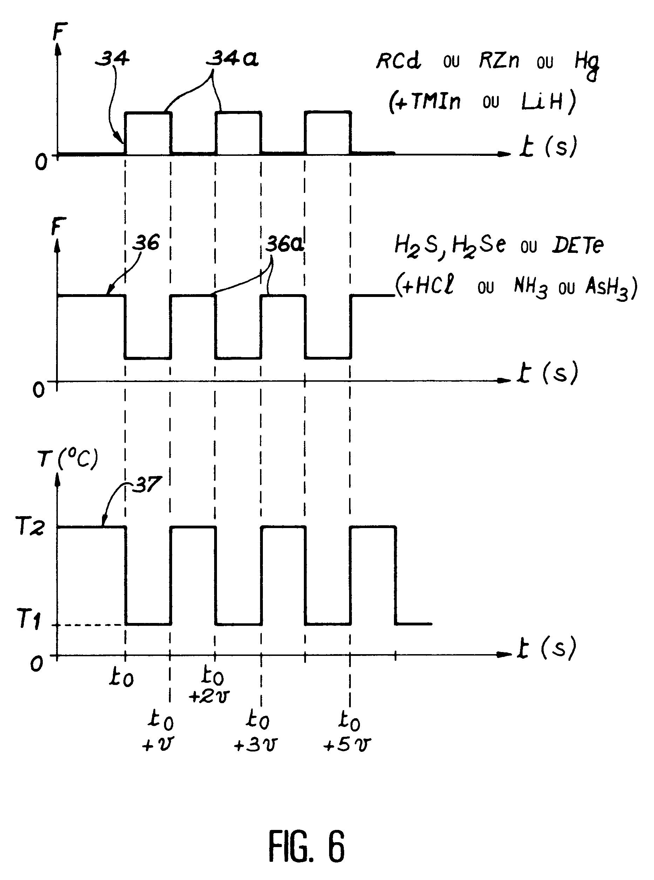

La figure 5 est relative au dépôt de couches ternaires du type $GaAs_x P_{1-x}$ avec 0 < x < 1 par décomposition thermique de TMGa, d'arsine et de phosphine. Dans ce type de matériau où la difficulté vient du fait que l'arsine et la phosphine qui devraient être introduites simultanément dans l'enceinte, en alternance avec l'introduction de TMGa, nécessitent des températures de décomposition différentes afin de rester dans des rendements de craquage raisonnables.

Aussi, le cycle d'incorporation de l'élément V de la couche à déposer est décomposé en deux parties, une partie haute température avec apport de la phosphine et une partie basse température avec apport de l'arsine.

Les courbes en forme de créneaux périodiques 27, 29 et 31 correspondent respectivement à la présence dans l'enceinte de dépôt de TMGa, d'arsine et de phosphine. La courbe 33 représente la modulation en température du substrat correspondante.

Comme précédemment, l'apport en gallium (palier 27a) est effectué pendant que le substrat est maintenu à la température la plus basse T1 et l'apport en éléments V est effectué pendant que le substrat est maintenu à une température, supérieure à T1.

Selon l'invention, l'apport en arsine sur le substrat III-V, représenté par les paliers 29a de la courbe 29 est réalisé pendant que le substrat est maintenu à la température T2 et l'apport en phosphine, symbolisé par les paliers 31a de la courbe 31, est effectué pendant que le substrat est maintenu à une température T3 supérieure à T2.

En régime de diffusion, la température T1 est égale à 500 ± 20°C, la température T2 est égale à 700 ± 20°C et la température T3 est égale à 800 ± 20°C.

Conformément à l'invention, la durée du palier T1 est égale à la durée des paliers T2 + T3 et à la durée des apports respectivement en gallium et en éléments V.

Pendant la présence de la phosphine dans l'enceinte de dépôt, la pression partielle d'arsine peut être annulée ou bien maintenue à une valeur inférieure à celle nécessaire pour permettre les réactions chimiques conduisant au dépôt de GaAs.

La durée de l'apport en gallium et celle des éléments V son voisines de 1 s et la pression des gaz est de $10^3$ Pa pour obtenir une monocouche de 0,3 nm de GaAsP. La durée respective des paliers 29a et 31a et donc des paliers de température T2 et T3 fixe la composition x du composé $GaAs_x P_{1-x}$.

De façon similaire, il est possible de faire croître des couches monocristallines en matériau quaternaire du type $Ga_xIn_{1-x}As_yP_{1-y}$ avec 0 < x < 1 et 0 < y < 1 par décomposition de TMGa, TMIn, d'arsine et d phosphine. Dans ce cas, comme décrit en référence à la figure 3, le TMIn est apporté simultanément au TMGa sur le substrat et ce dernier est maintenu à la température T1 voisine de 500°C pendant toute la durée de l'apport en éléments III. Les pressions partielles de TMGa et de TMIn dans l'enceinte de dépôt définissent la valeur de x.

Conformément à l'invention, il est aussi possible de faire croître des couches semi-conductrices en matériau II-VI.

A cet effet, on a représenté sur la figure 6 la croissance d'une couche en matériau binaire II-VI dopé ou non. Les courbes 34 et 36 se rapportent respectivement à l'apport en élément II et à l'apport en élément VI sur un substrat monocristallin en II-VI, III-V ou IV par exemple d'orientation cristalline [100]. Ces courbes se présentent encore sous la forme d'une série d'impulsions périodiques en forme de créneaux.

Pour des couches où l'élément II doit être du Cd, les paliers 34a correspondent à l'alimentation en diméthylcadmium ou en diéthylcadmium (noté RCd) de l'enceinte de dépôt.

Pour des couches ou l'élément II est du Zn, les gaz introduits pendant les paliers 34a sont du diméthylzinc ou du diéthylzinc (RZn).

Quand l'élément II est du Hg, on introduit habituellement pendant les paliers 34a des vapeurs de Hg.

Les paliers 36a correspondent à l'alimentation en $H_2S$ ou $H_2Se$ ou éthyltellure de l'enceinte de dépôt suivant que l'élément VI de la couche doit être du soufre, du sélénium ou du tellure.

Les paliers 34a et 36a sont alternés.

Simultanément à cette modulation des gaz de dépôt, on effectue une modulation de la température du substrat sur lequel doit s'effectuer le dépôt de la couche de II-VI. La courbe 37, correspondant à cette modulation en température, se présente aussi sous la forme d'impulsions thermiques périodiques en forme de créneaux comportant alternativement des paliers de température T1 et des paliers de température T2 avec T2 > T1.

Comme le montre la figure 6, le substrat est porté à la température T1 lorsque l'on introduit dans l'enceinte de dépôt le gaz devant fournir, par décomposition thermique sur le substrat, l'élément II et le substrat est porté à la température T2 lorsque l'on introduit dans l'enceinte de dépôt le gaz devant fournir, par décomposition thermique sur le substrat, l'élément VI. Les alimentations en gaz et la modulation en température sont parfaitement synchronisées.

Les températures T1 et T2 sont optimisées pour avoir les meilleurs rendements de décomposition des différents gaz utilisés. Les gammes de températures utilisées sont :

$$\text{pour DMCd, DECd, DMZn ou DEZn} \quad 250°C \leqslant T1 \leqslant 500°C,$$
$$\text{pour vapeurs de Hg} \quad 20°C \leqslant T1 \leqslant 300°C,$$
$$\text{pour DMTe ou DETe} \quad 400°C \leqslant T2 \leqslant 500°C,$$
$$\text{pour } H_2S \text{ ou } H_2Se \quad 400°C \leqslant T2 \leqslant 650°C.$$

Les temps de présence des gaz dans l'enceinte sont identiques. De même, la durée du palier T1 est identique à la durée du palier T2. Pour des températures T1 et T2 optimisées, la demi-période v des impulsions de la courbe 37 est égale à 1 s, ce qui est le temps nécessaire pour déposer une monocouche de II-VI non dopé, soit une épaisseur de l'ordre de 0,3 nm avec une pression partielle du gaz actif dans la gamme des 10 à $10^3$ Pa.

La durée totale de l'apport en gaz (paliers 34a et 36a) nécessaire au dépôt et donc celle du traitement thermique (paliers T1 et T2) sont directement proportionnelles à l'épaisseur de la couche de II-VI que l'on désire obtenir.

Le dépôt d'une couche en matériau II-VI est généralement précédé d'une étape de préparation de la surface du substrat sur laquelle s'effectue le dépôt. Cette préparation consiste en un apport en élément VI à la surface du substrat. C'est pour cette raison que le premier gaz introduit dans l'enceinte de dépôt est celui de l'élément VI et que l'on commence en portant le substrat à la température T2. La durée de cette étape n'est pas critique. Il suffit qu'elle soit supérieure à la seconde pour les pressions partielles de gaz indiquées précédemment.

Les défauts natifs, du type lacunes d'éléments II ou lacunes d'éléments VI, dont la concentration dépend de façon assez critique de la température de croissance, se comportent comme des dopants naturels. Ceci est l'un des problèmes majeurs dans le dopage des couches II-VI qui ne peut pas être réalisé de façon aussi contrôlée que pour les couches de composés III-V.

Néanmoins, il est bien établi que les éléments III (Al, Ga et In) et les éléments VII (Cl, I, F) jouent le rôle de donneurs dans la plupart des composés II-VI et donc permettent de doper du type n les couches II-VI ; les éléments I (Li, Na) et les éléments V (N, As, P) jouent par contre le rôle d'accepteurs et donc permettent de doper du type p les couches II-VI.

Dans les exemples de croissance de couches binaires IIVI, ces éléments dopants sont obtenus par décomposition thermique de leurs polyalkyles ou de leurs hydrures.

Pour réaliser le dopage n on introduit, soit les composts fournissant l'élément III en même temps que ceux donnant l'élément II pendant les paliers 34a indiques sur la figure 6, soit les composés fournissant l'élément VII en même temps que ceux donnant l'élément VI pendant les paliers 36a indiqués sur la figure 6, tout ceci sans rien changer au cycle de température indiqué par la courbe 37.

Par exemple pour le dopage n d'une couche de ZnSe, on introduit soit du TMIn dans le même cycle que le RZn, soit du HCl dans le cycle $H_2Se$. Les proportions des pressions partielles de ces gaz sont en rapport avec le niveau de dopage souhaité.

Pour réaliser le dopage p, on introduit soit les composés fournissant l'élément I en même temps que ceux

EP 0 300 904 B1

libérant l'élément II, c'est-à-dire pendant les paliers 34a de la figure 6, soit les composés fournissant l'élément V en même temps que ceux libérant l'élément VI, c'est-à-dire pendant les paliers 36a de la figure 6.

Par exemple, pour le dopage p d'une couche de ZnSe, on introduit du $NH_3$ ou du $AsH_3$ ou du $PH_3$ en même temps que le $H_2Se$, dans les proportions de pressions partielles souhaitées pour le niveau de dopage recherché, sans rien changer au cycle thermique indiqué par la courbe 37 de la figure 6.

De même que pour les couches III-V, on peut réaliser un empilement de couches II-VI de même composition AB mais dopées différemment. Il suffit pour cela d'effectuer des cycles d'entrée de gaz et de modulation de température du substrat en rapport avec les épaisseurs de couches et les alternances de dopage. On peut ainsi obtenir des structures np, ni, pi, nipi, etc.

Il est aussi possible de faire croître des couches ternaires du type $Cd_xHg_{1-x}Te$ avec $0 < x < 1$, ou les éléments II sont de deux types et l'élément VI d'un seul type, par décomposition thermique de DMCd et de DETe en présence de vapeurs de Hg. Le cycle d'introduction des gaz est dans ce cas identique à celui illustré sur le figure 3 par les courbes 13 et 15. Les paliers 13a correspondent alors à l'introduction simultanée des gaz fournissant les éléments II, c'est-à-dire du DMCd et des vapeurs de Hg. La courbe 15 correspond au cycle d'introduction du gaz fournissant l'élément VI ici le DETe.

Le substrat est porté à la température T1 < T2 pendant l'apport en Cd et en Hg et successivement à la température T2 pendant l'apport en Te. La durée des impulsions thermiques et de l'apport en gaz de dépôt v varie de 1 à 10 s afin d'obtenir une monocouche de $Cd_xHg_{1-x}Te$ de l'ordre de 0,3 nm d'épaisseur. La valeur de l'indice x est fixée par le rapport des pressions partielles de DMCd et de vapeurs d'Hg régnant dans l'enceinte de dépôt.

La croissance de couches ternaires en $Cd_x\,Hg_{1-x}\,Te$ peut encore être optimisée en introduisant non plus simultanément mais séparément le DMCd et les vapeurs d'Hg toujours dans les proportions de pressions partielles fixées par le x souhaité. Ceci permet d'abaisser, si besoin, la température TI pendant l'introduction d'Hg à pratiquement la température ambiante.

Le dopage n ou p de ces couches II-VI ternaires est réalisé comme décrit précédemment pour les couches II-VI binaires en référence à la figure 6.

La croissance d'un pseudo-alliage ou de couches alternées du type HgTe/CdTe, où seul l'élément II change d'une couche à l'autre, par décomposition thermique de DMCd et de DETe et des vapeurs d'Hg se fait suivant un cycle identique à celui décrit dans la figure 4. Les courbes 19, 21 et 23 correspondent alors respectivement à l'apport en DMCd, en vapeurs d'Hg et en DETe. La courbe 25 représente la modulation en température associée à cette modulation en gaz de croissance. Les parties I de cette figure correspondent dans ce cas au dépôt d'HgTe et les parties II correspondent au dépôt CdTe.

Le dépôt de CdTe se fait comme décrit précédemment en référence à la figure 6, les apports en DMCd et DETe étant alternés, l'apport en DMTe se faisant à la température T2 et l'apport en TMCd à la température T'1 avec T'1 < T2. T'1 et T2 sont respectivement voisins de 390°C et 450°C.

De même, les apports en Hg et DETe sont alternés. La température du substrat est maintenue à la température T2 de décomposition du DETe pendant l'apport en DETe et le substrat est maintenu à la température T1 qui peut être comprise entre T'1 et la température ambiante, pendant l'apport en vapeurs d'Hg.

Le cycle de dépôt d'HgTe puis celui de CdTe sont répétés autant de fois que nécessaire suivant l'épaisseur de la couche de pseudo-alliage que l'on désire obtenir. Le rapport des durées des parties I et II fixe la composition moyenne du pseudo-alliage.

Le dopage n ou p de ce pseudo-alliage est en particulier réalisé dans les mêmes conditions que celles décrites en référence à la figure 6.

Des couches de ternaires du type $Zn\,Se_xS_{1-x}$ avec $0 < x < 1$ et deux types d'éléments VI, peuvent être réalisés par un cycle identique a celui décrit sur la figure 3. Les paliers 13a correspondent alors à l'introduction du RZn. Les paliers 15a correspondent à l'introduction simultanée de $H_2S$ et de $H_2Se$.

Le substrat est porté à la température T1 < T2 pendant l'introduction de RZn et successivement à la température T2 pendant l'introduction du $H_2S$ et $H_2Se$. La durée des impulsions thermiques et de l'apport en gaz de dépôt v varie de 1 à 10 s afin d'obtenir une monocouche de $ZnSe_xS_{1-x}$ de l'ordre de 0,3 nm d'épaisseur. La valeur de l'indice x est fixé par le rapport des pressions partielles de $H_2Se$ et de $H_2S$ régnant dans l'enceinte de dépôt pendant le palier 15a. La température T1 peut êre choisie entre 350°C et 450°C et T2 entre 500°C et 600°C.

De façon similaire, il est possible de faire croître des couches monocristallines en matériau quaternaire du type $Zn_yCd_{1-y}Se_xS_{1-x}$ avec $0 < x < 1$ et $0 < y < 1$ par décomposition de DMZn, DMC, $H_2Se$ et $H_2S$. Dans ce cas, comme décrit en référence à la figure 3, le DMZn est introduit simultanément au DMCd (pendant les paliers 13a), le substrat est maintenu à la température T1 voisine de 400°C pendant toute la durée de l'apport en éléments II. Le rapport des pressions partielles de DMZn et de DMCd dans l'enceinte de dépôt définit la valeur de y. Le $H_2S$ est introduit simultanément au $H_2Se$ (pendant les paliers 15a), le substrat est maintenu a tempé-

10

rature T2 voisine de 600°C pendant toute la durée de l'apport en éléments VI. Le rapport des pressions partielles de $H_2S$ et de $H_2Se$ pendant les paliers 15a définit la valeur de x.

Le dépôt de couches ternaires du type $CdSe_x Te_{1-x}$ avec $0 < x < 1$ par décomposition thermique de DMCd, de $H_2Se$ et de DETe peut être réalisé suivant le cycle décrit sur la figure 5. Le cycle d'incorporation des éléments VI de la couche à déposer est décomposé en deux parties, une partie haute température pendant l'introduction de $H_2Se$ et une partie basse température pendant l'introduction du DETe.

Les courbes en forme de créneaux périodiques 27, 29 et 31 correspondent alors respectivement à la présence dans l'enceinte de dépôt de DMCd, de DETe et de $H_2Se$. La courbe 33 représente la modulation en température du substrat correspondante. L'apport en Cd (paliers 27a) est effectué pendant que le substrat est maintenu à la température la plus basse T1 et l'apport en éléments VI est effectué pendant que le substrat est maintenu à une température supérieure à T1.

Selon l'invention, l'apport en DETe (paliers 29a) est réalisé pendant que le substrat est maintenu à la température T2 et l'apport en $H_2Se$ (paliers 31a) est effectué pendant que le substrat est maintenu une température T3 supérieure à T2.

Par exemple, la température T1 peut être égale à 400° ± 20°C, la température T2 peut être égale à 450° ± 20°C et la température T3 peut être égale à 600° ± 50°C ; la durée du palier T1 est encore égale à la somme des durées des paliers T2 et T3.

Pendant la présence de DETe dans l'enceinte de dépôt, la pression partielle de $H_2Se$ peut être annulée ou bien maintenue à une valeur inférieure à celle nécessaire pour permettre la pyrolyse conduisant à la libération de l'élément Se.

La durée de l'apport en Cd et celle de l'apport en éléments VI sont voisines de 1 s et les pressions partielles des gaz sont dans la gamme des $10^3$ Pa pour obtenir une monocouche de 0,3 nm de $CdSe_xTe_{1-x}$ le rapport des durées des paliers fixe la composition x du composé.

Sur la figure 7, on a représenté schématiquement un dispositif permettant la mise en oeuvre du procédé selon l'invention.

Ce dispositif à configuration horizontale comporte une enceinte à vide 50 dans laquelle sont placés, dans un tube en quartz, plusieurs substrats 52 monocristallins en matériau III-V ou II-VI sur lesquels on veut déposer une couche semi-conductrice selon l'invention.

Les supports-échantillons doivent avoir une inertie thermique la plus faible possible et ne pas être en contact avec les substrats afin de permettre la modulation en température pour contrôler les dépôts à la monocouche près.

Les gaz nécessaires à la croissance épitaxiale des couches semi-conductrices sont introduits à l'une des extrémités 54 de l'enceinte 50, l'autre extrémité étant utilisée pour l'évacuation des gaz de réaction ($CH_4$, $C_2H_6$ notamment), des gaz n'ayant pas réagi et éventuellement pour la mise sous vide de l'enceinte 50.

Sur la figure 7, on a représenté cinq conduites d'amenée de gaz 56a-56e. La conduite 56a sert par exemple à l'introduction d'arsine ou d'ammoniac ; la conduite 56b sert à l'introduction d'un gaz neutre tel qu'un gaz rare ou de l'azote en vue de purger tout le dispositif entre chaque changement de gaz ; la conduite d'amenée 56c sert par exemple à l'introduction de la phosphine, d'$H_2S$ ou HX (X étant un halogène) ; la conduite d'amenée 56d sert à l'introduction des gaz organo-métalliques du type RM où R représente le radical triméthyle, triéthyle ou diéthyle et M un métal de la colonne III ou VI du tableau périodique des éléments, et la conduite d'amenée 56e sert par exemple à l'introduction de vapeurs métalliques et en particulier de mercure.

Les conduites d'amenée 56a-56e des différents gaz sont équipées d'électrovannes 58 et de débitmètres massiques 59 servant à régler et stabiliser le débit gazeux des différents gaz, ces électrovannes et débitmètres étant commandés par un circuit électronique de commande 60.

Un manomètre 62 relié à un circuit électronique de lecture 64 permet de mesurer la pression régnant à l'intérieur de l'enceinte 50. Ces informations de mesure sont envoyées vers un calculateur 66 pilotant alors le circuit électronique de commande 60 des électrovannes 58.

L'enceinte à vide 50 est placée dans un four à lampes à halogène 68 permettant de moduler la température des substrats 52, en regard des lampes, conformément à l'invention.

Comme four à lampes à halogène utilisable, on peut citer le four "Machine Heat Pulse" par A.G. Associated (Palo Alto, Californie, US) ou "Machine Addax" par AET (Chemin de Malacher ZIRST, Meylan, France). Ces machines présentent les caractéristiques de montée et de descente en température données précédemment.

Des sondes de mesure de la température 70 (du type thermocouple) situées à l'intérieur de l'enceinte 50 permettent de mesurer la température des substrats 52. La température mesurée est envoyée via un circuit électronique de lecture 72 vers le calculateur 66 en vue de réguler la température de chauffe des substrats 52 ainsi que la durée des impulsions thermiques. A cet effet, le calculateur 66 est relié à un circuit électronique 74 de commande et d'alimentation électrique des lampes à halogène 68.

Le dispositif décrit ci-dessus permet une régulation automatique des températures de chauffage des substrats 52 ainsi qu'une régulation de débit gazeux synchronisée en fonction de la nature des couches en matériau III-V ou II-VI à déposer, conformément à l'invention.

La description précédente a bien entendu été donnée à titre illustratif, d'autres modifications pouvant être envisagée. En particulier, le dispositif de mise en oeuvre du procédé selon l'invention peut avoir une configuration verticale au lieu d'une configuration horizontale et être équipé d'autres conduites de gaz. En outre, d'autres couches semi-conductrices en matériau II-VI ou III-V et d'autres alternances de gaz que celles illustrées peuvent être utilisées, conformément au procédé selon l'invention.

## Revendications

1. Procédé de croissance par épitaxie sur un substrat d'une couche semi-conductrice monocristalline formée a) d'au moins un élément III et d'au moins un élément V ou b) d'au moins un élément II et d'au moins un élément VI, consistant à soumettre le substrat, simultanément à l'apport en espèces chimiques donnant les éléments entrant dans la composition de ladite couche, à une série d'impulsions thermiques (5, 11, 17, 25, 33, 37) en forme de créneaux comportant alternativement des paliers de température T1 et des paliers de température T2 supérieures à la température ambiante, avec T1 < T2, l'apport en espèces chimiques (1a, 7a, 13a, 27a, 34a) donnant l'élément III ou II de la couche étant effectué pendant que le substrat est à la température T1 et l'apport en espèces chimiques (3a, 9a, 15a, 29a, 31a, 36a) donnant l'élément V ou VI de la couche étant effectué pendant que le substrat est à la temperature T2.

2. Procédé selon la revendication 1, caractérisé en ce que la durée de l'apport en espèces chimiques est égal à la durée du palier de température correspondant.

3. Procédé selon la revendication 1 ou 2, caractérisé en ce que le substrat est réalisé en un matériau III-V, II-VI ou IV, d'orientation [100].

4. Procédé selon l'une quelconque des revendications 1 à 3, caractérisé en ce que les espèces chimiques sont des vapeurs métalliques, d'organo-métalliques et/ou des vapeurs de composés hydrogénés.

5. Procédé selon l'une quelconque des revendications 1 à 4, caractérisé en ce que l'on soumet le substrat aux impulsions thermiques à l'aide de lampes à halogène (68).

6. Procédé selon l'une quelconque des revendications 1 à 5, caractérisé en ce que l'on effectue la croissance à des pressions allant de $10^2$ à $10^6$ Pa.

7. Procédé selon l'une quelconque des revendications 4 à 6, caractérisé en ce que T1 et T2 correspondent aux températures de décomposition thermique des espèces chimiques à la surface du substrat donnant respectivement l'élément III ou II et l'élément V ou VI de la couche.

8. Procédé selon l'une quelconque-des revendications 1 à 7, caractérisé en ce que l'élément III est choisi parmi le gallium, l'indium, l'aluminium et leurs mélanges et en ce que l'élément V est choisi parmi le phosphore, l'arsenic, l'antimoine et leurs mélanges.

9. Procédé selon l'une quelconque des revendications 1 à 7, caractérisé en ce que l'élément II est choisi parmi le zinc, le cadmium, le mercure et leurs mélanges et en ce que l'élément VI est choisi parmi le soufre, le sélénium, le tellure et leurs mélanges.

10. Procédé selon l'une quelconque des revendications 4 à 9 appliqué à la croissance d'une couche semi-conductrice comportant deux éléments de la même colonne de la classification périodique pour lesquels les températures de décomposition des espèces chimiques donnant ces deux éléments sont voisines, caractérisé en ce que les apports (13a) en espèce chimique de ces deux éléments sur le substrat sont réalisés simultanément.

11. Procédé selon l'une quelconque des revendications 4 à 9 appliqué à la croissance d'une couche semi-conductrice comportant deux éléments de la même colonne de la classification périodique pour lesquels les températures de décomposition des espèces chimiques donnant ces deux éléments sont différentes, caractérisé en ce que les apports (29a, 31a) en espèce chimique de ces deux éléments sur le substrat sont réalisés successivement et en ce que les impulsions thermiques présentent des paliers de température supplémentaires T3, avec T1 < T3 < T2 pendant lesquels on effectue l'apport (29a) de l'espèce chimique ayant la température de décomposition la plus basse.

12. Procédé selon l'une quelconque des revendications 1 à 11 appliqué à la croissance d'une couche semi-conductrice dopée n, caractérisé en ce que l'on apporte au substrat (3a, 36a) l'espèce chimique donnant le dopant n pendant que le substrat est à la température T2.

13. Procédé selon l'une quelconque des revendications 1 à 11 appliqué à la croissance d'une couche semi-conductrice dopée p, caractérisé en ce que l'on apporte au substrat (1a, 34a) l'espèce chimique donnant le dopant p pendant que le substrat est à la température T1.

14. Procédé selon l'une quelconque des revendications 9 à 11 appliqué à la croissance d'une couche semi-conductrice II-VI dopée n, caractérisé en ce que l'on apporte au substrat (34a) l'espèce chimique donnant le dopant n pendant que le substrat est à la température T1.

15. Procédé selon l'une quelconque es revendications à 11 appliqué à la croissance d'une couche semi-conductrice II-VI dopée p, caractérisé en ce que l'on apporte au substrat (36a) l'espèce chimique donnant le dopant p pendant que le substrat est à la température T2.

**Patentansprüche**

1. Verfahren zum epitaktischen Aufwachsenlassen einer monokristallinen Halbleiterschicht aus (a) mindestens einem Element der Gruppe III und mindestens einem Element der Gruppe V des PSE oder aus (b) mindestens einem Element der Gruppe II und mindestens einem Element der Gruppe VI des PSE auf ein Substrat, das darin besteht, daß man das Substrat gleichzeitig mit der Zufuhr der Elemente, die in die Zusammensetzung der genannten Schicht eintreten, in Form von chemischen Substanzen einer Reihe von thermischen Impulsen (5, 11, 17, 25, 33, 37) in Form von Stufen (Pulsen) unterwirft, die alternativ umfassen Temperaturstufen T1 und Temperaturstufen T2, die oberhalb der Umgebungstemperatur liegen, mit T1 < T2, wobei die Zuführung an chemischen Substanzen (1a, 7a, 13a, 27a, 34a), die das Element III oder II der Schicht liefern, durchgeführt wird, während das Substrat die Temperatur T1 hat, und die Zuführung an chemischen Substanzen (3a, 9a, 15a, 29a, 31a, 36a), die das Element V oder VI der Schicht liefern, durchgeführt wird, während das Substrat die Temperatur T2 hat.

2. Verfahren nach Anspruch 1, dadurch gekennzeichnet, daß die Dauer der Zuführung von chemischen Substanzen gleich der Dauer der entsprechenden Temperaturstufe ist.

3. Verfahren nach Anspruch 1 oder 2, dadurch gekennzeichnet, daß das Substrat aus einem Material III-V, II-VI oder IV mit der Orientierung [100] besteht.

4. Verfahren nach einem der Ansprüche 1 bis 3, dadurch gekennzeichnet, daß es sich bei den chemischen Substanzen handelt um Metalldämpfe, Dämpfe von metallorganischen Verbindungen und/oder Dämpfe von hydrierten Verbindungen.

5. Verfahren nach einem der Ansprüche 1 bis 4, dadurch gekennzeichnet, daß man das Substrat mit Hilfe von Halogenlampen (68) den thermischen Impulsen unterwirft.

6. Verfahren nach einem der Ansprüche 1 bis 5, dadurch gekennzeichnet, daß man das Aufwachsenlassen unter Drucken von $10^2$ bis $10^6$ Pa durchführt.

7. Verfahren nach einem der Ansprüche 4 bis 6, dadurch gekennzeichnet, daß T1 und T2 den thermischen Zersetzungstemperaturen der chemischen Substanzen an der Oberfläche des Substrats entsprechen, die jeweils das Element III oder II und das Element V oder VI der Schicht liefern.

8. Verfahren nach einem der Ansprüche 1 bis 7, dadurch gekennzeichnet, daß das Element III ausgewählt wird aus Gallium, Indium, Aluminium und Mischungen davon und daß das Element V ausgewählt wird aus Phosphor, Arsen, Antimon und Mischungen davon.

9. Verfahren nach einem der Ansprüche 1 bis 7, dadurch gekennzeichnet, daß das Element II ausgewählt wird aus Zink, Cadmium, Quecksilber und Mischungen davon und daß das Element VI ausgewählt wird aus Schwefel, Selen, Tellur und Mischungen davon.

10. Verfahren nach einem der Ansprüche 4 bis 9, angewendet auf das Aufwachsenlassen einer Halbleiterschicht, die zwei Elemente der gleichen Gruppe des PSE enthält, für welche die ZerSetzungstemperaturen der chemischen Substanzen, die diese beiden Elemente liefern, benachbart zueinander liegen, dadurch gekennzeichnet, daß die Zuführungen (13a) an chemischer Substanz dieser beiden Elemente auf dem Substrat gleichzeitig durchgeführt werden.

11. Verfahren nach einem der Ansprüche 4 bis 9, angewendet auf das Aufwachsenlassen einer Halbleiterschicht, die zwei Elemente der gleichen Gruppe des PSE enthält, für welche die Zersetzungstemperaturen der chemischen Substanzen, die diese Elemente liefern, verschieden sind, dadurch gekennzeichnet, daß die Zuführungen (29a, 31a) in Form einer chemischen Substanz dieser beiden Elemente auf das Substrat nacheinander durchgeführt werden und daß die thermischen Impulse zusätzliche Temperaturstufen T3 aufweisen mit T1 < T3 < T2, während der die Zuführung (29a) der chemischen Substanz mit der niedrigsten Zersetzungstemperatur durchgeführt wird.

12. Verfahren nach einem der Ansprüche 1 bis 11, angewendet auf das Aufwachsenlassen einer mit n dotierten Halbleiterschicht, dadurch gekennzeichnet, daß man dem Substrat (3a, 36a) die chemische Substanz, die das Dotierungsmittel n liefert, zuführt, während das Substrat die Temperatur T2 hat.

13. Verfahren nach einem der Ansprüche 1 bis 11, angewendet auf das Aufwachsenlassen einer mit p dotierten Halbleiterschicht, dadurch gekennzeichnet, daß man dem Substrat (1a, 34a) die chemische Substanz zuführt, die das Dotierungsmittel p liefert, während das Substrat die Temperatur T1 hat.

14. Verfahren nach einem der Ansprüche 9 bis 11, angewendet auf das Aufwachsenlassen einer mit n dotierten II-VI-Halbleiterschicht, dadurch gekennzeichnet, daß man dem Substrat (34a) die chemische Substanz, die das Dotierungsmittel n liefert, zuführt, während das Substrat die Temperatur T1 hat.

15. Verfahren nach einem der Ansprüche 9 bis 11, angewendet auf das Aufwachsenlassen einer mit p dotierten II-VI-Halbleiterschicht, dadurch gekennzeichnet, daß man dem Substrat (36a) die chemische Substanz, die das Dotierungsmittel p liefert, zuführt, während das Substrat die Temperatur T2 hat.

## Claims

1. Process for growth by epitaxy on a substrate of a monocrystalline semiconductor layer formed a) by at least one element III and at least one element V or b) of at least one element II and at least one element VI, consisting of subjecting the substrate, simultaneously with the supply of the chemical species giving the elements entering into the composition of said layer, to a series of square-wave heat pulses (5, 11, 17, 25, 33, 37) alternately having temperature ranges T1 and temperature ranges T2 exceeding ambient temperature, with T1 < T2, the supply of chemical species (1a, 7a, 13a, 27a, 34a) giving the element III or II of the layer being carried out whilst the substrate is at temperature T1 and the supply of chemical species (3a, 9a, 15a, 29a, 31a, 36a) giving the element V or VI of the layer being carried out whilst the substrate is at temperature T2.

2. Process according to claim 1, characterized in that the duration of the supply of the chemical species is equal to the duration of the corresponding temperature range.

3. Process according to claim 1 or 2, characterized in that the substrate is made from III-V, II-VI or IV material of orientation [100].

4. Process according to any one of the claims 1 to 3, characterized in that the chemical species are metallic, organometallic and/or hydrogen compound vapours.

5. Process according to any one of the claims 1 to 4, characterized in that the substrate is subjected to heat pulses with the aid of tungsten halogen lamps (68).

6. Process according to any one of the claims 1 to 5, characterized in that growth takes place at pressures between $10^2$ and $10^6$ Pa.

7. Process according to any one of the claims 4 to 6, characterized in that T1 and T2 correspond to the thermal decomposition temperatures of the chemical species at the surface of the substrate respectively giving element III or II and element V or VI of the layer.

8. Process according to any one of the claims 1 to 7, characterized in that element III is chosen from among gallium, indium, aluminium and mixtures thereof and that element V is chosen from among phosphorous, arsenic, antimony and mixtures thereof.

9. Process according to any one of the claims 1 to 7, characterized in that element II is chosen among zinc, cadmium, mercury and mixtures thereof and in that element VI is chosen from among sulphur, selenium, tellurium and mixtures thereof.

10. Process according to any one of the claims 4 to 9, applied to the growth of a semiconductor layer having two elements of the same column of the periodic classification for which the decomposition temperatures of the chemical species giving said to elements are close to one another, characterized in that the chemical species supplies (33a) of these two elements to the substrate are carried out simultaneously.

11. Process according to any one of the claims 4 to 9, applied to the growth of a semiconductor layer having two elements of the same column of the periodic classification for which the decomposition temperatures of the chemical species giving these two elements differ, characterized in that the chemical species supplies (29a, 31a) of these two elements to the substrate are performed successively and in that the heat pulses have supplementary temperature ranges T3, with T1 < T3 < T2 during which the supply (29a) takes place of the chemical species with the lowest decomposition temperature.

12. Process according to any one of the claims 1 to 11, applied to the growth of a n doped semiconductor layer, characterized in that substrate (3a, 36a) is supplied with the chemical species giving the n dopant whilst the substrate is at temperature T2.

13. Process according to any one of the claims 1 to 11, applied to the growth of a p doped semiconductor layer, characterized in that substrate (1a, 34a) is supplied with the chemical species giving the p dopant whilst the substrate is at temperature T1.

14. Process according to any one of the claims 9 to 11, applied to the growth of a n doped II-VI semiconductor layer, characterized in that the substrate (34a) is supplied with the chemical species giving the n dopant whilst the substrate is at temperature T1.

15. Process according to any one of the claims 9 to 11, applied to the growth of a p doped II-VI semiconductor layer, characterized in that the substrate (36a) is supplied with the chemical species giving the p dopant whilst the substrate is at temperature T2.

FIG. 1

FIG. 2

FIG. 3

13 13a TMGa +TEIn

15 15a AsH₃

T₂ 17

T₁

$t_0$   $t_0 +2\upsilon$   $t_0 +4\upsilon$   $t_0 +6\upsilon$

FIG. 5

27 27a TMGa

29 29a AsH₃

31 31a PH₃

T₃ 33

T₂

T₁

$t_0$   $t_0 +2\upsilon$   $t_0 +4\upsilon$

FIG. 4

FIG. 6

FIG. 7